# EUROPÄISCHE PATENTANMELDUNG

(11) **EP 4 749 297 A1**
(43) Veröffentlichungstag der Anmeldung: **27.05.2026**
(21) Anmeldenummer: 25216904.0
(22) Anmeldetag: 19.11.2025
(51) Int. Cl.: G01R 1/20, G01R 31/28, G01R 31/34, G01R 31/385

(54) **PRÜFFELD MIT SICHERER FREISCHALTUNG EINES GLEICHSPANNUNGS-ANSCHLUSSES**

(30) Priorität: 22.11.2024 DE 102024211238; 20.03.2025 DE 102025110880
(71) Anmelder: ZF Friedrichshafen AG, 88046 Friedrichshafen (DE)
(72) Erfinder: GOTTSCHALLER, Sebastian, 94113 Tiefenbach (DE); STUEBENER, Dirk, 80995 München (DE)
(74) Vertreter: ZF Friedrichshafen AG

(57) **Zusammenfassung**

Ein Prüffeld (2) für Prüflinge (4) mit Energiequellen (12) und mit über einen Gleichspannungs-Bus (30) mit diesen verbundenen Prüfstationen (20) mit Gleichspannungs-Anschluss (28) für die Prüflinge (4), enthält die Prüfstation (20) einen Resonanzkonverter (22) mit Transformator (32), und einen PWM-Generator (38), um bei Versorgung mit einer Betriebsspannung (UB) die Primärseite (34) des Transformators (32) mit einem PWM-Signal (PS) aus der Gleichspannung (UG) am Gleichspannungs-Bus (30) zu versorgen, und einen zwischen Sekundärseite (36) des Transformators (32) und Gleichspannungs-Anschluss (28) angeordneten Schalter (44), um diese elektrische Verbindung zu unterbrechen, enthält einer Sicherheitssteuerung (46), um in einem Sicherungszustand (SZ) den PWM-Generator (38) von der Betriebsspannung (UB) abzuschalten und den Schalter (44) zu öffnen.

Bei einer Raumanordnung (52) mit mindestens zwei Räumen (54,56,58) und mit dem Prüffeld (2) ist dieses verteilt über wenigstens zwei der Räume (54,56,58) in der Raumanordnung (52) derart angeordnet, dass der Gleichspannungsanschluss (28) in einem ersten der Räume (54,56,58) angeordnet ist und wenigstens ein Teil des restlichen Prüffeldes (2) in einem zweiten der Räume (54,56,58) angeordnet ist.

## Beschreibung

Die Erfindung betrifft ein Prüffeld. Ein hier in Rede stehendes Prüffeld dient zur elektrischen Prüfung von Prüflingen, z.B. elektrischen Antrieben oder Fahrbatterien von Elektrofahrzeugen, unter Gleichspannung bei vergleichsweise hohen Leistungen im Zig-kW-Bereich. An mehreren Prüfstationen des Prüffeldes ist jeweils einer der Prüflinge anschließbar bzw. angeschlossen. Dabei können die Prüflinge elektrische Leistung aus der Prüfstation aufnehmen und / oder an diese abgeben.

Aus der WO 2021 / 174278 A1 ist es bekannt, dass elektrisch betriebene Prüfstände regelmäßig Umrichteranordnungen mit mehreren Umrichtern umfassen, sei es nun für die Prüfung der Antriebsstränge von Elektrofahrzeugen, Hybridfahrzeugen, herkömmlichen Fahrzeugen mit Verbrennungsmotor, der mechanischen Komponenten wie dem Getriebe, oder den Batteriespeichern selbst. Gerade die Prüfung der Batteriespeicher erfolgt oft parallel, wobei mehrere Batteriezellen, Batteriemodule oder Batteriepacks gleichzeitig mit parallel angeordneten Umrichtern geprüft werden.

Aufgabe der Erfindung ist es, Verbesserungen in Bezug auf ein Prüffeld vorzuschlagen.

Die Aufgabe wird gelöst durch ein Prüffeld gemäß Patentanspruch 1. Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Das Prüffeld ist ein solches für Prüflinge, dient also zur Prüfung bzw. zum Anschluss von Prüflingen. Das Prüffeld dient zum elektrischen Test der Prüflinge. Getestet werden die Prüflinge mithilfe eines in den jeweiligen Prüfling einzuspeisenden und / oder aus diesem abzuführenden elektrischen Stromes. Dabei ist das Prüffeld so dimensioniert, dass der Prüfling einer vergleichsweise starken elektrischen Leistung ausgesetzt werden kann. Das Prüffeld ist hierbei für vergleichsweise starke elektrische Belastungen der Prüflinge ausgelegt. Der Nennwert / Maximalwert der möglichen elektrischen Leistung pro Prüfling beträgt, typisch 250kW bis 1MW, bei einer Nennspannung von typisch ca. 200V bis ca. 800V und einem Nennstrom von typisch 1000 bis 2000A.

Das Prüffeld enthält einen Gleichspannungs-Bus zum Führen einer Gleichspannung.

Das Prüffeld enthält wenigstens eine Energiequelle. Die Energiequelle kann elektrische Leistung in das restliche Prüffeld speisen, ggf. auch aus diesem aufnehmen. Die Begriffe "Quelle / Erzeugung / usw." sind hier also weit zu verstehen: Die "Energiequelle" z.B. ist hier ggf. bidirektional ausgelegt und bei Bedarf auch als Energiesenke betreibbar.

Die jeweilige Energiequelle weist eine erste Gleichspannungs-Schnittstelle auf, um unter Gleichspannung Leistung an den Gleichspannungs-Bus abzugeben, insbesondere auch aufzunehmen.

Das Prüffeld enthält außerdem eine Mehrzahl von Prüfstationen. Jede der Prüfstationen dient zur Prüfung bzw. zum Anschluss je eines Prüflings.

Jede der Prüfstationen weist eine zweite Gleichspannungs-Schnittstelle für den Gleichspannungs-Bus auf. Jede der Prüfstationen weist auch einen Gleichspannungs-Anschluss auf. Dieser dient zum Anschluss des jeweiligen Prüflings.

Im Prüffeld sind alle Prüfstationen mit ihren zweiten Gleichspannungs-Schnittstellen an dem Gleichspannungs-Bus angeschlossen. Auch alle Energiequellen sind mit ihren ersten Gleichspannungs-Schnittstellen an dem Gleichspannungs-Bus angeschlossen. So sind also alle Energiequellen und Prüfstationen über den Gleichspannungs-Bus miteinander elektrisch leitend verbunden und können per Gleichspannung Energie miteinander austauschen.

Jede der Prüfstationen enthält einen Resonanzkonverter. Jeder der Resonanzkonverter enthält einen Transformator, der wiederum eine Primärseite und eine Sekundärseite aufweist. Die Primärseite ist der zweiten Gleichspannungs-Schnittstelle zugewandt bzw. elektrisch mit dieser verbunden, die Sekundärseite entsprechend dem Gleichspannungs-Anschluss.

Jede der Prüfstationen enthält einen PWM-Generator. Dieser ist dazu eingerichtet, den Transformator an dessen Primärseite mit einem aus der Gleichspannung an der zweiten Gleichspannungs-Schnittstelle erzeugten PWM-Signal zu versorgen. Dies gelingt dem PWM-Generator jedoch nur dann, wenn er mit einer Betriebsspannung versorgt ist. Ohne Betriebsspannung kann dieser kein PWM-Signal erzeugen. Der Transformator ist dann keiner oder allenfalls einer Gleichspannung ausgesetzt. Hierdurch wird aber keine Energie von der Primär- zur Sekundärseite übertragen. Auf der Sekundärseite kann somit keine Spannung, vor allem aber keine Leistung erzeugt werden. So kann auch keine Spannung an dem Gleichspannungsanschluss erzeugt werden. Dieser ist damit spannungsfrei geschaltet.

Jede der Prüfstationen enthält außerdem einen Schalter, welcher zwischen Sekundärseite des Transformators und Gleichspannungs-Anschluss der Prüfstation angeordnet bzw. geschaltet ist. Der Schalter ist insbesondere im Gleichspannungspfad der Prüfstation angeordnet. Der Schalter ist wenigstens einpolig, insbesondere zweipolig ausgeführt. Der Schalter dient dazu, eine elektrische Verbindung zwischen Sekundärseite und Gleichspannungs-Anschluss entweder zu unterbrechen oder herzustellen, je nachdem ob dieser geöffnet oder geschlossen ist. Bei geöffnetem Schalter ist ein zusätzlicher (zur o.g. Abschaltung der Betriebsspannung) Schutz etabliert, um den Gleichspannungs-Anschluss spannungsfrei zu schalten.

Das Prüffeld enthält eine Sicherheitssteuerung, insbesondere enthält jede Prüfstation eine Sicherheitssteuerung. Diese ist dazu eingerichtet sich wahlweise in einem Sicherungszustand zu befinden bzw. in diesen geschaltet zu sein. Der Sicherungszustand kann pro Prüfstation einzeln aktiviert oder deaktiviert werden. Im Sicherungszustand ist die Sicherheitssteuerung dazu eingerichtet, bezüglich des oder der gewählten (Sicherungszustand für diese aktiv) Prüfstationen folgende Maßnahmen zu ergreifen: Im Sicherungszustand schaltet die Sicherheitssteuerung den PWM-Generator in der betreffenden Prüfstation von der Betriebsspannung ab und hält diesen abgeschaltet. Außerdem öffnet sie den Schalter in der betreffenden Prüfstation und hält diesen offen.

Mit anderen Worten sorgt die Sicherheitssteuerung in der betreffenden Prüfstation dafür, dass der PWM-Generator im Sicherungszustand nicht mehr von der Betriebsspannung versorgt ist und somit kein PWM-Signal mehr erzeugen kann, um den Transformator hiermit zu versorgen. Die Leistungsübertragung über den Transformator ist damit verhindert. Außerdem unterbricht die Sicherheitssteuerung die elektrische Verbindung zwischen Transformator bzw. dessen Sekundärseite und dem Gleichspannungs-Anschluss in der betreffenden Prüfstation. Im Ergebnis ist der Gleichspannungs-Anschluss in der betreffenden Prüfstation spannungs- und leistungsfrei.

Wird die Sicherungseinrichtung dagegen für eine oder mehrere der Prüfstationen nicht im Sicherheitsmodus, sondern z.B. in einem Normalmodus betrieben, stellt sie die Betriebsspannung am PWM-Generator her, so dass dieser das PWM-Signal erzeugen kann und schließt den Schalter, so dass eine elektrische Verbindung zwischen Transformator und Gleichspannungs-Anschluss gegeben ist. Die Prüfstation kann dann zum Prüfen von Prüflingen genutzt werden.

Dank der Maßnahmen ist sichergestellt, dass im Sicherungszustand durch den außer Betrieb gesetzten (galvanisch trennend aufgebauten) Transformator eine galvanische Trennung zwischen dessen Primär- und Sekundärseite gegeben ist. Der Gleichspannungs-Anschluss ist somit nur noch "bis zur Sekundärseite" mit dem Transformator verbunden und ansonsten galvanisch von dem restlichen Prüffeld (Primärseite, Zwischenkreis / Gleichspannungs-Bus, Energiequelle) getrennt. Als zweite Sicherheitsstufe bzw. in redundanter Weise wird außerdem noch die elektrische Verbindung zwischen der Sekundärseite und dem Gleichspannungs-Anschluss durch den Schalter unterbrochen.

Somit können sichere Arbeiten am Gleichspannungs-Anschluss ausgeführt werden, da dieser spannungsfrei geschaltet ist, obwohl das Prüffeld an sich in Betrieb bleiben kann und so ggf. restliche Gleichspannungs-Anschlüsse, welche sich nicht im Sicherungszustand befinden, zum Prüfen von Prüflingen genutzt werden können.

In manchen Fällen ist am Ausgang der Prüfstation zunächst noch eine Prüfvorrichtung, z.B. eine sogenannte DC-Box angeschlossen. Erst an dieser ist dann der eigentliche Prüfling (DUT: Device Under Test) angeschlossen / anschließbar. Die DC-Box (z.B. in Form eines Schaltschrankes) ist dagegen fest am Ausgang der Prüfstation angeschlossen. Handhabungen an spannungsführenden Teilen, wie sie hier abzusichern sind, finden dann streng genommen am Ausgang der DC-Box statt. Insofern ist der Begriff "Gleichspannungs-Anschluss" hier vorliegend weit zu verstehen und kann auch der Prüfstation nachgeschaltet entfernt von dieser liegen. Die hier getroffenen Aussagen gelten jedoch sinngemäß. Anders betrachtet, könnte dann auch die Prüfvorrichtung noch als Teil der Prüfstation verstanden werden. Die Prüfstation endet dann am Ausgang der Prüfvorrichtung mit dem Gleichspannungs-Anschluss, der dort anzuschließende "Prüfling" reduziert sich dann auf das DUT.

In einer bevorzugten Ausführungsform ist der Schalter kein Trennschalter oder Lasttrennschalter. Die Begriffe sind hier im engen technischen Sinn zu verstehen, siehe z.B. https://de.wikipedia.org/wiki/Trennschalter und https://de.wikipedia.org/wiki/Lasttrennschalter, Internetseiten, Abruf jeweils am 16.01.2025. Somit kann dank des Sicherungskonzepts auf einen teuren, aufwändigen und großvolumige Trennschalter verzichtet werden.

In einer bevorzugten Variante dieser Ausführungsform ist der Schalter ein Schaltschütz. Auch dieser Begriff ist im engen technischen Sinn zu verstehen, siehe z.B. https://de.wikipedia.org/wiki/Sch%C3%BCtz_(Schalter), Internetseite, Abruf am 16.01.2025. Aufgrund des erfindungsgemäßen Sicherheitskonzeptes können auch vergleichsweise günstige, unaufwändige und kleinvolumige Schaltschütze zum sicheren Freischalten des Gleichspannungs-Anschlusses genutzt werden, da der Schaltschütz neben der Außerbetriebsetzung des Transformators lediglich als redundantes Element in das Sicherheitskonzept eingebunden ist.

In einer bevorzugten Ausführungsform weist die Sicherheitssteuerung eine Sicherungsvorrichtung auf, die dazu eingerichtet ist, die Prüfstation gegen Wiedereinschalten der Betriebsspannung am PWM Generator und Schalter der betreffenden Prüfstation sichert. So ist sichergestellt, dass ein versehentliches Inbetriebsetzen des PWM Generators oder Schließen des Schalters und damit eine Gefährdung von Personen, die am Gleichspannungs-Anschluss der betreffenden Prüfstation arbeiten, ausgeschlossen ist. Somit kann - nach Freischalten des Gleichspannungs-Anschlusses - in fachüblicher Weise sichergestellt werden, dass ein Wiedereinschalten des Gleichspannungs-Anschlusses sicher verhindert ist. Arbeiten an dem Gleichspannungs-Anschluss sind somit gefahrlos möglich. Die Sicherungsvorrichtung ist z.B. ein Befestigungsmittel für ein bei Vorhandensein / Anbringung das Wiedereinschalten des Trennschalters verhinderndes Vorhängeschloss.

In einer bevorzugten Ausführungsform enthält das Prüffeld wenigstens ein Bedienelement. Dieses ist dazu eingerichtet, in der Sicherheitssteuerung bezüglich wenigstens einer der Prüfstationen den Sicherungszustand zu aktivieren. Mit anderen Worten steuert das Bedienelement die Sicherheitssteuerung zur Abschaltung der Betriebsspannung und des Schalters an. Das Bedienelement ist am Gleichspannungs-Anschluss angeordnet. Eine Anordnung "am Gleichspannungs-Anschluss" ist so zu verstehen, dass das Bedienelement in einem bestimmten Entfernungsradius vom korrelierten Gleichspannungs-Anschluss angeordnet ist, zum Beispiel innerhalb einer Entfernung von höchstens 30cm, höchstens 50cm, höchstens 100 cm, höchstens 2m oder höchstens 5m. Somit ist eine örtliche Korrelation zwischen Gleichspannungs-Anschluss und Bedienelement gegeben. Ein Bediener kann somit intuitiv erkennen, dass das Bedienelement dem entsprechenden Gleichspannungs-Anschluss zugeordnet ist, um diesen freizuschalten. Insbesondere ist folgendes denkbar: In Bezug auf mehrere bzw. alle Gleichspannungs-Anschlüsse ist das Bedienelement jeweils näher an dem ihm zugeordneten Gleichspannungs-Anschluss als an allen anderen Gleichspannungs-Anschlüssen angeordnet.

In einer bevorzugten Variante dieser Ausführungsform ist das Bedienelement eine Fernsteuerung für die entfernt von diesem angeordnete Sicherheitssteuerung. Mit anderen Worten ist es möglich bzw. dann gegeben, das Bedienelement entfernt von der Sicherheitssteuerung angebracht ist, um von dort aus den Gleichspannungs-Anschluss spannungsfrei zu schalten bzw. zu sichern. Somit ist es möglich, die Sicherheitssteuerung entfernt vom Bedienelement anzuordnen, zum Beispiel in der Nähe der PWM-Steuerung, des Transformators oder des Schalters usw. Auch wenn der Gleichspannungs-Anschluss vergleichsweise weit von der PWM-Steuerung / dem Transformator /dem Schalter entfernt liegt, zum Beispiel in verschiedenen Räumen eines Gebäudes bzw. einer Raumanordnung mit den Räumen.

In einer bevorzugten Ausführungsform ist der Gleichspannungs-Anschluss über eine Versorgungsleitung mit der restlichen Prüfstation verbunden und entfernt von der restlichen Prüfstation angeordnet. So kann beispielsweise die restliche Prüfstation in einem ersten Raum eines Gebäudes / einer Raumanordnung, der Gleichspannungs-Anschluss jedoch in einem anderen Raum angeordnet sein. Zum Beispiel ist die restliche Prüfstation zusammen mit dem Generator in einem speziell gekühlten Versorgungsraum angeordnet, der Gleichspannungs-Anschluss jedoch in einem Testraum für Prüflinge.

In einer bevorzugten Ausführungsform ist der Prüfling nicht über einen Steckverbinder mit dem Gleichspannungs-Anschluss verbunden oder verbindbar. Insbesondere für die vorliegend betrachteten Hochleistungs-Tests an Prüflingen muss eine entsprechend zuverlässige elektrische Hochleistungs-Verbindung zwischen Gleichspannungs-Anschluss und Prüfling bestehen. Durch den Verzicht auf Steckverbinder ist dies zuverlässig möglich. Die Verbindung erfolgt z.B. vermittels einer direkten Kontaktierung / Montage anhand von Stromschienen. Dank des Sicherheitskonzepts zum Freischalten des Gleichspannungs-Anschlusses ist jedoch beim Rüsten eine sichere Handhabung auch ohne Steckverbinder, z.B. an den Stromschienen, möglich.

In einer bevorzugten Ausführungsform enthält die Prüfstation eine Überwachungseinheit. Die Überwachungseinheit enthält eine Ausgabeeinheit. Die Ausgabeeinheit ist am Gleichspannungs-Anschluss angeordnet. Für die eine Anordnung "am Gleichspannung-Anschluss" gelten sinngemäß die oben zum Bedienelement getroffenen Aussagen. Die Überwachungseinheit ist dazu eingerichtet, im Sicherungszustand zu überwachen, ob an der betreffenden Prüfstation der PWM-Generator tatsächlich nicht mit der Betriebsspannung versorgt ist und ob die elektrische Verbindung über den Schalter zwischen Sekundärseite des Transformators und Gleichspannungs-Anschluss tatsächlich getrennt ist. Für den Fall, dass zumindest eine dieser Bedingungen nicht erfüllt ist, ist die Überwachungseinheit dazu eingerichtet, eine Warnmeldung an der Ausgabeeinheit bereitzustellen bzw. auszugeben. In diesem Fall verhindert die Überwachungseinheit aus Sicherheitsgründen auch ein Wiedereinschalten der Prüfstation. Somit ist eine sichere Abschaltung auch bei Auftreten eines einzelnen Fehlers gewährleistet.

In einer bevorzugten Variante dieser Ausführungsform enthält das Prüffeld, insbesondere die Überwachungseinheit, eine (Eigen-)Diagnoseeinheit. Diese ist die der Überwachungseinheit zugeordnet und dazu eingerichtet, eine (Eigen-)Diagnose der Funktionsfähigkeit der Überwachungseinheit durchzuführen. Die Diagnose beruht insbesondere darauf, eine Zwischenkreis-Spannung zu überwachen, die im Betrieb am Ausgang des Transformators auftritt und in den Tiefsetzsteller eingespeist wird. Geprüft wird insbesondere die Entladung dieser Spannung innerhalb einer bestimmten Maximalzeit.

Falls gemäß der Diagnose die Funktionsfähigkeit nicht festgestellt wird oder ist, ist die Diagnoseeinheit dazu eingerichtet, das Prüffeld in einen permanenten Fehlerzustand zu versetzten. "Permanent" bedeutet, dass der Fehlerzustand nicht von innerhalb des Prüffeldes zurückgesetzt werden kann. Ein derartiger Fehlerzustand kann nur auf spezielle Weise von außerhalb des Prüffeldes, zum Beispiel von einem Servicetechniker, wieder zurückgesetzt werden. Somit ist eine weitere Sicherheitsstufe gegeben, die auch eine Fehlfunktion der Überwachungseinheit abdeckt.

Die Aufgabe der Erfindung wird auch durch eine Raumanordnung gemäß Patentanspruch 11 gelöst.

Die Raumanordnung enthält mindestens zwei Räume und das erfindungsgemäße Prüffeld. Das Prüffeld ist verteilt über wenigstens zwei der Räume in der Raumanordnung derart angeordnet, dass der Gleichspannungsanschluss in einem ersten der Räume angeordnet ist und wenigstens ein Teil des restlichen Prüffeldes in einem zweiten, anderen der Räume angeordnet ist.

Insbesondere ist, wie oben schon erläutert, das Bedienelement in dem ersten Raum angeordnet, nämlich als Fernsteuerung für die zumindest teilweise in dem anderen Raum angeordnete Sicherheitssteuerung.

Insbesondere ist, wie oben schon erläutert, der Gleichspannungs-Anschluss in dem ersten Raum über eine Versorgungsleitung mit der restlichen Prüfstation verbunden, die zumindest teilweise in dem anderen Raum angeordnet ist.

Die Raumanordnung erlaubt einen modularen und vorteilhaften Aufbau des gesamten Prüffeldes, so dass Teile des Prüffeldes in speziell dafür eingerichteten Räumen untergebracht werden können. So können einzelne Räume z.B. gekühlt oder belüftet oder beheizt sein. Auch können einzelne Räume nur bestimmten Personen / Personenkreisen (Wartungstechniker / Bedien- / Testpersonal) zugänglich sein.

Die Erfindung beruht auf folgenden Erkenntnissen, Beobachtungen bzw. Überlegungen und weist noch die nachfolgenden bevorzugten Ausführungsformen auf. Diese Ausführungsformen werden dabei teils vereinfachend auch "die Erfindung" genannt. Die Ausführungsformen können hierbei auch Teile oder Kombinationen der oben genannten Ausführungsformen enthalten oder diesen entsprechen und/oder gegebenenfalls auch bisher nicht erwähnte Ausführungsformen einschließen.

Gemäß der Erfindung ergibt sich eine sichere Freischaltung von DC-Spannungsquellen (Gleichspannungs-Anschluss).

Es ergibt sich eine Kombination der sicheren Trennung mittels Transformator und der redundanten Abschaltung mittels Schalter (insbesondere DC-Schütz) zur Erreichung einer insbesondere fernsteuerbaren sicheren Freischaltung.

Aus der Praxis ist eine ggf. umständliche Freischaltung über AC-Hauptschalter des kompletten Geräts, d.h. Prüffeldes (z.B. an der Energiequelle) oder eine nicht sichere Abschaltung des DC-Ausgangs bekannt. Gemäß der Erfindung ergibt sich ein Erreichen eines hohen Sicherheitsstandards bei insbesondere fernsteuerbarer, sicherer Freischaltung. Es ergibt sich, dass eine Freischaltung direkt am Anschlusspunkt über Fernsteuerung möglich ist.

Die Erfindung befasst sich mit folgenden betrachteten Geräten / Topologien: Bei den betrachteten Geräten handelt es sich um hochdynamische, rückspeisfähige DC-Spannungsquellen und -senken (Prüfstation) für den Test von elektrischen Komponenten (Prüfling) und zur Simulation von Batterien und anderen elektrischen Speichern in Prüfständen (Prüfmodul). Typische Prüflinge sind dabei Antriebs- und Speicherkomponenten wie Batterien, elektrische Antriebe, Stromrichter, Brennstoffzellen, Solarzellen oder Supercaps.

Bei den betrachteten Topologien wird aus den Abgangs-Schienen (Gleichspannungs-Anschluss) jeweils eine hohe DC-Leistung (typ. 250kW bis 1MW) bei hohen Spannungen (bis 1500V) und hohen Strömen (bis 2000A) bereitgestellt.

Hierbei können eine oder mehrere Prüfstationen an einer Energiequelle angeschlossen sein.

Die Erfindung beruht auf folgenden Erkenntnissen:
Beim Rüsten (Wechsel des Prüflings, insbesondere des DUT an einer Prüfvorrichtung) muss an den Abgangsschienen der Prüfstation (Gleichspannungs-Anschluss, ggf. Ausgang der Prüfvorrichtung, siehe oben) gearbeitet werden, um den Prüfling direkt an den Schienen kontaktieren zu können. Der Einsatz von Steckverbindern ist bei den hohen Strömen und Spannungen sehr aufwändig bzw. nur bedingt oder teilweise gar nicht möglich.

Bei diesem Rüstvorgang müssen somit aktive Teile (Teile die gefährliche Spannung führen können) berührt werden. Daher sind Maßnahmen zu ergreifen, um den Schutz vor elektrischem Schlag beim Rüsten zu gewährleisten.

Die Grundregel gegen Schutz vor elektrischem Schlag lautet:
- spannungsführende Teile müssen gegen Berührung geschützt sein. Dies ist hier nicht umsetzbar, da die Schienen für Kontaktierung blank sein müssen.
- berührbare Teile dürfen keine gefährliche Spannung führen Hieraus folgt: Die Spannungsfreiheit muss sichergestellt werden.

Das Sicherstellen der Spannungsfreiheit erfolgt in der Praxis durch Einhalten von Sicherheitsregeln. Wesentlich im vorliegenden Kontext sind zwei Punkte: Freischalten und gegen Wiedereinschalten sichern. Dies erfordert eine sichere Trennung, die z.B. durch Schaltgeräte wie Leistungsschalter, Lasttrennschalter, Sicherungs-Lasttrennschalter hergestellt werden kann.

Hieraus ergibt sich vorliegend folgende Problemstellung:
Bei den vorliegenden Topologien entspräche dies dem Ausschalten und Sichern der Netztrenneinrichtung (Hauptschalter) in der Energiequelle. Dies hat jedoch folgende Nachteile:
- Der Hauptschalter kann in einem entfernten Raum liegen, wenn die Anlage (Prüffeld) über mehrere Räume verteilt installiert ist, was in der Regel auch der Fall ist.
- Die Zuordnung zwischen Arbeitsstelle (Ort des Gleichspannungs-Anschlusses bzw. des Prüflings bzw. der Prüfvorrichtung) und Netztrenneinrichtung (Ort der Netztrenneinrichtung) muss über Pläne oder Kennzeichnungen erfolgen, auf die sich der Monteur verlassen muss.
- Es ist kein intuitiver Zusammenhang zwischen Trennstelle (Ort der Netztrenneinrichtung) und Arbeitsstelle (Ort des Gleichspannungs-Anschlusses bzw. des Prüflings bzw. der Prüfvorrichtung) gegeben.
- Das Ausschalten erfordert das mehrmalige Zurücklegen von Wegstrecken, dies kann als unbequeme Tätigkeit zur Vermeidungsreaktion führen.
- Von der Energiequelle können weitere Prüfstände (andere Prüfstationen) am gleichen DC-Zwischenkreis (Gleichspannungs-Bus) versorgt werden, die u. U. während der Montagearbeiten in Betrieb bleiben sollen. In diesem Fall kann der Hauptschalter der Energiequelle nicht ausgeschaltet werden. Dies kann durch organisatorischen Druck auf den Monteur dazu führen, dass dieser ohne vorgeschriebene Freischaltung rüstet.

Die genannten Nachteile können dazu führen, dass die Sicherheitsvorschriften (organisatorische Maßnahmen) missachtet werden und bei eingeschaltetem Hauptschalter gerüstet wird.

Hintergrund zur Erfindung ist folgende Risikoeinschätzung bezüglich des SicherheitsRisikos:
- Der Mitarbeiter muss bei seiner Tätigkeit an der DC-Box (Gleichspannungs-Anschluss / Prüfvorrichtung) arbeiten, um dort Prüflinge (DUT) zu rüsten. Hierbei muss er auch an die Sammelschiene der Anlage.
- Aufgrund der hohen Gefahrenlage und dem damit verbundenen hohen Risiko, ergibt sich ein Hochrisiko-Szenario (Risikohöhe 4 von 5 möglichen Stufen).
- Die Sammelschienen sind elektrisch aktive Teile mit Spannungen bis 1000V DC.
- Das Risiko ist der elektrische Schlag, dieser kann zu schweren Verletzungen oder zum Tod führen.
- Somit ist ein hohes Maß an technischer und funktionaler Sicherheit gefordert.

Die Risikoabschätzung beruht auf folgenden Annahmen:
- Zu erwarten ist schwerwiegender Schaden (irreversibel) oder Tod
- Die Exposition ist selten bis weniger-häufig und/oder kurze Exposition

Die Erfindung beruht auf folgender Idee:
Aufgrund des hohen Gefahrenpotentials in Verbindung mit der vorhersehbaren Fehlanwendung bzw. Vermeidungsreaktion bei Freischaltung mittels Hauptschalter ist eine Möglichkeit der sicheren Freischaltung direkt am Anschlusspunkt (Gleichspannungs-Anschluss / Prüfvorrichtung / DC-Box) nötig.

Aus Platz- und Kostengründen soll kein zusätzlicher Trennschalter (im engen Sinne, siehe oben) am Anschlusspunkt verbaut werden, sondern es soll die sichere Freischaltung per Fernsteuerung vom Anschlusspunkt zum restlichen Prüffeld erfolgen. Des Weiteren sollen die bereits in Prüffeldern aus der Praxis vorhanden Schalt- und Stellglieder für die Freischaltung verwendet werden können.

Im aus der Praxis bekannten Prüffeld stehen dafür zwei Mechanismen zur Verfügung:
1. Ausgangsschütze DC-seitig (am Gleichspannungs-Ausgang)
2. Trenntransformatoren zur Primär/Sekundär-Trennung (im Resonanzkonverter)

Zu 1.:
   Schütze sind nach Normenlage nicht als eigenständiger Schutz gegen elektrischen Schlag zulässig. Da diese aber unabhängig von dieser Festlegung einen Beitrag zur Diversität und Redundanz der Trennung liefern können, werden die DC-seitigen Ausgangsschütze in das Schutzkonzept mit einbezogen.
Zu 2.:
   Transformatoren mit sicherer Trennung werden in der Praxis generell als Schutz gegen elektrischen Schlag akzeptiert, wenn diese auf der Sekundärseite ungefährliche Spannungsniveaus erzeugen. Darunter fallen u. a. alle Arten von Consumer-Netzteilen/Ladegeräten für Elektronik-Geräte.
   Im Gegensatz zu diesen Geräten erzeugen die Trenntransformatoren in der Prüfstation eine Ausgangsspannung, deren Berührung lebensgefährlich ist. Eine sichere Trennung mit diesen Transformatoren aufzubauen bedeutet, dass diese Transformatoren abgeschaltet werden müssen, also ein Energiefluss über diese Transformatoren verhindert werden muss.
   Ein Energiefluss über einen Transformator ist nur möglich, wenn an dessen Eingangsklemmen eine Wechselspannung anliegt. Diese Wechselspannung wird im Prüffeld durch einen Wechselrichter (Teil des Resonanzkonverters) erzeugt, der durch ein PWM-Signal aus einer internen Steuerung (PWM-Generator) angesteuert wird.
   Das Prinzip der sicheren Trennung am Transformator basiert nun darauf, dass der Steuerung (PWM-Generator), die das PWM Signal erzeugt und überträgt, über einen sicheren Pfad die Betriebsspannung entzogen wird. Ohne PWM kann der Wechselrichter, auch bei Ausfall von Komponenten, keine Wechselspannung erzeugen, womit eine Energieübertragung über die Transformatoren nicht mehr möglich ist.

Mit der Kombination von Ausgangsschützen und Trennung über Transformatoren wird im Prüffeld eine gleichwertige oder bessere Methode zum "Freischalten" und "gegen Wiedereinschalten sichern", verglichen mit den in der Praxis etablierten Methoden erreicht.

Dies wird insbesondere durch eine kontinuierliche Überwachung (Überwachungseinheit) beider redundanten Abschaltpfade und der internen Diagnose der Funktionsfähigkeit der Funktion (Diagnoseeinheit) gewährleistet. Diese Diagnosefunktion umfasst insbesondere die Überwachung der Entladung der gefährlichen Zwischenkreis-spannung im Gerät innerhalb einer bestimmten Zeit. Bei Verletzung dieser Bedingung geht das Gerät in einem permanenten Fehlerzustand der insbesondere nur durch einen Service-Techniker zurückgesetzt werden kann, da mit einem Hardware-Defekt zu rechnen ist.

Weitere Merkmale, Wirkungen und Vorteile der Erfindung ergeben sich aus der nachfolgenden Beschreibung eines bevorzugten Ausführungsbeispiels der Erfindung sowie den beigefügten Figuren. Dabei zeigen, jeweils in einer schematischen Prinzipskizze:

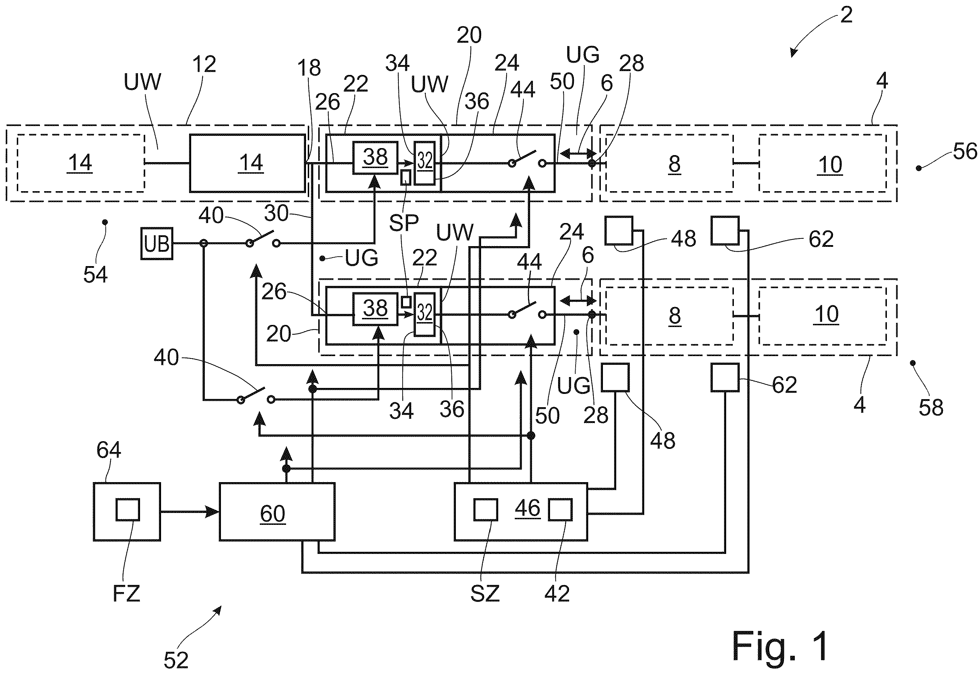

- Figur 1: ein Prüffeld mit zwei Prüfstationen und einer Energiequelle in einem schematischen Blockschaltbild.

Figur 1 zeigt ein Prüffeld 2 für hier zweipolige Prüflinge 4. Im Beispiel sind tatsächlich zwei Prüflinge 4 am Prüffeld 2 angeschlossen. Mithilfe des Prüffeldes 2 wird ein elektrischer Test an den Prüflingen 4 durchgeführt. Hierzu wird eine elektrische Stark-Leistung 6, hier von bis zu 1MW - je nach Test - in den Prüflingen 4 eingespeist oder aus diesem abgeführt. Die Stark-Leistung 6 ist im Beispiel durch einen Doppelpfeil gekennzeichnet.

Im Beispiel ist jeder der Prüflinge 4 in Form einer Prüfvorrichtung 8, hier einer sogenannten DC-Box, und dem eigentlichen Prüfling in Form eines DUT 10 (Device Under Test) dargestellt. Die beiden DUTs 10 sind vorliegend eine Fahrbatterie und ein Antriebsmotor eines Elektrofahrzeugs. Die DC-Box dient dem Anschluss des eigentlichen Prüflings in Form des DUT 10 an das Prüffeld 2.

Das Prüffeld 2 enthält eine Energiequelle 12, die wiederum einen Generator 14 sowie einen Umrichter 16 enthält. Der Generator 14 stellt im Betrieb eine Wechselspannung UW bereit, hier im Beispiel eine dreiphasige Wechselspannung von 400 V. Der Umrichter 16 ist an den Generator 14 angeschlossen und dient dazu, die Wechselspannung UW in eine hier zweipolige (Plus- und Minuspol) Gleichspannung UG umzurichten, welche an einer ersten hier zweipoligen Gleichspannungs-Schnittstelle 18 des Umrichters 16 bzw. der Energiequelle 12 anliegt.

Das Prüffeld 2 enthält außerdem zwei Prüfstationen 20. Jede der Prüfstationen 20 dient zum hier ebenfalls zweipoligen Anschluss genau eines der Prüflinge 4.

Jede der Prüfstationen 20 enthält einen Resonanzkonverter 22 sowie einen Tiefsetzsteller 24. Der Resonanzkonverter 22 bzw. die Prüfstation 20 weist eine zweite zweipolige Gleichspannungs-Schnittstelle 26 auf. Der Tiefsetzsteller 24 bzw. die Prüfstation 20 weist an der dem Resonanzkonverter 22 abgewandten Seite einen zweipoligen Gleichspannungs-Anschluss 28 für den jeweiligen Prüfling 4 auf. Der Resonanzkonverter 22 konvertiert die Gleichspannung UG an der zweiten Gleichspannungs-Schnittstelle 26 in eine Wechselspannung UW, welche vom Tiefsetzsteller 24 wiederum in eine Gleichspannung UG am Gleichspannungs-Anschluss 28 umgesetzt wird. Ggf. ist unter dem Gleichspannungs-Anschluss 28 hier auch der Ausgang der Prüfvorrichtung 8 zu verstehen, an der das DUT 10 angeschlossen wird, wie oben schon erläutert wurde, wenn dieser Ausgang als "Schnittstelle" abzusichern ist, um dort Arbeiten, z.B. das Rüsten von DUTs 10, sicher ausführen zu können.

Das Prüffeld 2 enthält außerdem einen zweipoligen Gleichspannungs-Bus 30. Die erste Gleichspannungs-Schnittstelle 18 und die zweiten Gleichspannungs-Schnittstellen 26 sind an dem Gleichspannungs-Bus 30 (dessen nicht dargestellten zwei Stromschienen) angeschlossen, um diese Komponenten elektrisch miteinander zu verbinden. So verteilt der Gleichspannungs-Bus 30 die Gleichspannung UG zwischen der Energiequelle 12 und den Prüfstationen 20.

Der Gleichspannungs-Bus 30 realisiert somit einen Gleichspannungs-Zwischenkreis im Prüffeld 2 und führt hier im Betrieb eine Gleichspannung UG von 825 V.

Jeder Resonanzkonverter 22 enthält einen Transformator 32, der eine Primärseite 34 und eine Sekundärseite 36 aufweist. Die Primärseite 34 ist der zweiten Gleichspannung Schnittstelle 26 zugewandt, die Sekundärseite 36 dem Gleichspannungs-Anschluss 28.

Jede Prüfstation 20 enthält außerdem einen PWM-Generator 38. Dieser ist jeweils mit einer Betriebsspannung UB versorgbar, wenn ein hier symbolisch zu verstehender Betriebsschalter 40 geschlossen ist. Der jeweilige PWM Generator 38 ist dazu eingerichtet, immer und nur dann, wenn er mit der Betriebsspannung UB versorgt ist, die Primärseite 34 des Transformators 32 mit einem PWM-Signal PS zu versorgen, welches aus der Gleichspannung UG an der zweiten Gleichspannungs-Schnittstelle 26 erzeugt ist bzw. wird.

Jede der Prüfstationen 20 enthält außerdem einen Schalter 44, der zwischen der Sekundärseite 36 des Transformators 32 und dem Gleichspannungs-Anschluss 28 angeordnet ist. Die Position des Schalters 44 in Figur 1 ist ebenfalls symbolisch zu verstehen, dieser muss nicht zwangsweise im Tiefsetzsteller 24 liegen. Der Schalter 44 ist dabei kein Trennschalter, sondern ein Schaltschütz.

Die Schalter 44 dienen dazu, die elektrische Verbindung zwischen Gleichspannungs-Anschluss 28 und Transformator 32 bzw. dessen Sekundärseite 36 zu unterbrechen oder herzustellen.

Das Prüffeld 2 enthält außerdem eine Sicherheitssteuerung 46, welche geleichermaßen beiden Prüfstationen 20 zugeordnet ist. Die Sicherheitssteuerung 46 ist dazu eingerichtet, bezüglich einer oder mehrerer der Prüfstationen 20 in einen Sicherungszustand SZ versetzt zu werden. In diesem schaltet sie in den betroffenen Prüfstationen 20 den PWM-Generator 38 von der Betriebsspannung UB ab, hier durch Öffnen des Schalters 40, und hält diesen abgeschaltet. Außerdem öffnet sie im Sicherungszustand SZ den Schalter 44 in den betroffenen Prüfstationen 20 und hält diesen offen.

Dies geschieht also selektiv für die ausgewählten Prüfstationen 20, wobei die restlichen Prüfstationen 20 des Prüffeldes 2 prinzipiell in Betrieb bleiben können.

Die Sicherheitssteuerung 46 enthält außerdem eine Sicherungsvorrichtung 42. Diese sichert vor einem Wiedereinschalten der Betriebsspannung UB (Schließen des Schalters 40) und einem Schließen des Schalters 44 bezüglich der betreffenden Prüfstationen 20. Somit stellt sie sicher, dass in den betreffenden Prüfstationen 20 nicht versehentlich wieder Spannung am Gleichspannungs-Anschluss 28 anliegt und dort zum Beispiel Personen gefährdet würden.

Das Prüffeld 2 enthält außerdem Bedienelemente 48, je eines für jede der Prüfstationen 20. Die Bedienelemente 48 sind dazu eingerichtet, die Sicherheitssteuerung 46 hinsichtlich der betreffenden Prüfstation 20 in den Sicherungszustand SZ zu versetzen bzw. diesen für die betreffende Prüfstation 20 zu aktivieren. Das Bedienelement 48 ist dabei jeweils am betreffenden Gleichspannungs-Anschluss 28 angeordnet, d.h. hier: in örtlicher Umgebung bzw. Reichweite eines Bedieners, der sich am Gleichspannungs-Anschluss 28 befindet und an diesem arbeiten möchte. So kann der Bediener das sich in der Nähe bzw. dort befindliche Bedienelement 48 bedienen und somit den Gleichspannungs-Anschluss 28 spannungsfrei schalten und gefahrlos an diesem arbeiten.

Die Bedienelemente 48 sind hier als Fernsteuerungen ausgelegt, da die Sicherheitssteuerung 46 entfernt von den Bedienelementen 48 angeordnet sind.

Figur 1 zeigt nämlich auch eine Raumanordnung 52 mit einem ersten Raum 54, zweiten Raum 56 und dritten Raum 58. Die Energiequelle ist zusammen mit der Sicherheitssteuerung 46 in dem ersten Raum 54, die in der Figur obere Prüfstation 20 zusammen mit ihrem Bedienelemente 48 in dem zweiten Raum 56 und die die in der Figur untere Prüfstation 20 zusammen mit ihrem Bedienelemente 48 in dem dritten Raum 56 angeordnet.

Der jeweilige Gleichspannungs-Anschluss 28 ist auch im zweiten Raum 56 / dritten Raum 58 angeordnet und über eine jeweilige Versorgungsleitung 50 mit der restlichen Prüfstation 20 im ersten Raum 54, hier dem Tiefsetzsteller 24, verbunden. Der Gleichspannungs-Anschluss 28 ist daher entfernt von der restlichen Prüfstation 20 angeordnet und nur über die Versorgungsleitung 50 mit dieser verbunden.

Figur 1 zeigt daher auch die Raumanordnung 52. Diese weist den ersten Raum 54 auf, in dem sowohl die Energiequelle 12 als auch die (restlichen) Prüfstationen 20 angeordnet sind. Der erste Raum 54 ist klimatisiert. Die Raumanordnung 52 weist auch den zweiten Raum 56 und einen dritten Raum 58 auf. Der erste Raum 54 stellt damit einen Versorgungsraum des Prüffelds 2 dar. Die der zweite und dritte Raum 56 und 58 sind Testräume. In diesen befinden sich die Prüflinge 4. Hierbei sind die Prüfvorrichtungen 8 festinstallierte Schaltschränke im zweiten Raum 56 bzw. dritten Raum 58, die mit eigentlichen Prüfplätzen verbunden sind, die in der Figur nicht näher dargestellt sind. An den Prüfplätzen werden dann die eigentlichen DUTs 10 an die Prüfvorrichtungen 8 angeschlossen, um jeweils geprüft zu werden.

Die Bedienelemente 48 sind also in dem jeweiligen zweiten Raum 56 und dritten Raum 58 angeordnet und sind somit zweifelsfrei mit dem betreffenden Gleichspannungs-Anschluss in 28 im zweiten Raum 56 oder dritten Raum 58 assoziiert, um diese sicher identifiziert zielgenau und schnell spannungsfrei zu schalten. Die Versorgungsleitungen 50 führen dann jeweils vom ersten Raum 54 sowohl zum zweiten Raum 56 als auch zum dritten Raum 58.

Die Prüflinge 4 sind hier nicht über Steckverbinder mit den Gleichspannungs-Anschlüssen 28 verbunden, sondern über nicht dargestellte Stromschienen, wobei zur Verbindung direkte Arbeiten an den nicht isolierten Stromschienen notwendig sind. Konkret sind die Stromschienen an den Stellen zwischen Prüfvorrichtung 8 und DUT 10 zu manipulieren.

Das Prüffeld 2 enthält auch eine Überwachungseinheit 60 mit Ausgabeeinheiten 62. Die Ausgabeeinheiten 62 sind ebenfalls an den betreffenden Gleichspannungs-Anschlüssen 28 angeordnet im zweiten Raum 56 und dritten Raum 58 angeordnet. Die Überwachungseinheit 60 ist dazu eingerichtet, im Sicherungszustand SZ zu überwachen, ob für die betreffende Prüfstation 20 der PWM Generator 38 tatsächlich nicht mit der Betriebsspannung UB versorgt ist und ob die elektrische Verbindung zwischen Transformator 32 und Gleichspannungs-Anschluss 28 durch den Schalter 44 tatsächlich unterbrochen ist. Falls nicht, ist die Überwachungseinheit 60 dazu eingerichtet, an der betreffenden Ausgabeeinheit 62 eine Warnmeldung auszugeben.

Der Überwachungseinheit 60 ist außerdem eine Eigendiagnoseeinheit 64 zugeordnet. Diese ist dazu eingerichtet, eine Eigendiagnose der Funktionsfähigkeit der Überwachungseinheit 60 durchzuführen. Falls die Funktionsfähigkeit nicht sichergestellt ist, ist sie dazu eingerichtet, das Prüffeld 2 in einen permanenten Fehlerzustand FZ zu versetzen. Dieser kann nur von außerhalb des Prüffeldes 2, hier von einem Servicetechniker zurückgesetzt werden, sobald die Funktionsfähigkeit wieder hergestellt ist.

### Bezugszeichen

- 2: Prüffeld
- 4: Prüfling
- 6: Stark-Leistung
- 8: Prüfvorrichtung
- 10: DUT
- 12: Energiequelle
- 14: Generator
- 16: Umrichter
- 18: erste Gleichspannungs-Schnittstelle
- 20: Prüfstation
- 22: Resonanzkonverter
- 24: Tiefsetzsteller
- 26: zweite Gleichspannungs-Schnittstelle
- 28: Gleichspannungs-Anschluss
- 30: Gleichspannungs-Bus
- 32: Transformator
- 34: Primärseite
- 36: Sekundärseite
- 38: PWM-Generator
- 40: Betriebsschalter
- 42: Sicherungsvorrichtung (Wiedereinschalten)
- 44: Schalter
- 46: Sicherheitssteuerung
- 48: Bedienelement
- 50: Versorgungsleitung
- 52: Raumanordnung
- 54: erster Raum
- 56: zweiter Raum
- 58: dritter Raum
- 60: Überwachungseinheit
- 62: Ausgabeeinheit
- 64: Eigendiagnoseeinheit

- UW: Wechselspannung
- UG: Gleichspannung
- UB: Betriebsspannung
- PS: PWM-Signal
- SZ: Sicherungszustand
- FZ: Fehlerzustand

## Patentansprüche

1. Prüffeld (2) für Prüflinge (4), zum elektrischen Test der Prüflinge (4) mit Hilfe einer in diese einzuspeisenden und / oder aus diesen abzuführenden elektrischen Stark-Leistung unter Gleichspannung (UG),
- mit einem Gleichspannungs-Bus (30) zum Führen einer Gleichspannung (UG),
- mit wenigstens einer Energiequelle (12) mit einer ersten Gleichspannungs-Schnittstelle (18) für den Gleichspannungs-Bus (30),
- mit einer Mehrzahl von Prüfstationen (20) für je einen der Prüflinge (4), die eine zweite Gleichspannungs-Schnittstelle (26) für den Gleichspannungs-Bus (30) und einen Gleichspannungs-Anschluss (28) für den jeweiligen Prüfling (4) enthält,
- wobei alle Prüfstationen (20) anhand deren zweiter Gleichspannungs-Schnittstellen (26) mit allen Energiequellen (12) anhand deren erster Gleichspannungs-Schnittstellen (18) über den Gleichspannungs-Bus (30) miteinander verbunden sind,
- wobei jede der Prüfstationen (20) einen Resonanzkonverter (22) enthält, der einen Transformator (32) mit einer der zweiten Gleichspannungs-Schnittstellen (26) zugewandten Primärseite (34) und einer dem Gleichspannungs-Anschluss (28) zugewandten Sekundärseite (36) enthält,
- wobei jede der Prüfstationen (20) einen PWM-Generator (38) enthält, der dazu eingerichtet ist, bei Versorgung mit einer Betriebsspannung (UB) die Primärseite (34) mit einem aus der Gleichspannung (UG) an der zweiten Gleichspannungs-Schnittstelle (26) erzeugten PWM-Signal (PS) zu versorgen,
- wobei jede der Prüfstationen (20) einen zwischen Sekundärseite (36) und Gleichspannungs-Anschluss (28) angeordneten Schalter (44) enthält, um eine elektrische Verbindung zwischen Sekundärseite (36) und Gleichspannungs-Anschluss (28) zu unterbrechen,
- mit einer Sicherheitssteuerung (46), die dazu eingerichtet ist, in einem Sicherungszustand (SZ) den PWM-Generator (38) von der Betriebsspannung (UB) abzuschalten und abgeschaltet zu halten und den Schalter (44) zu öffnen und offen zu halten.

2. Prüffeld (2) nach Anspruch 1,
**dadurch gekennzeichnet, dass**
der Schalter (44) kein Trennschalter oder Lasttrennschalter ist.

3. Prüffeld (2) nach Anspruch 2,
**dadurch gekennzeichnet, dass**
der Schalter (44) ein Schaltschütz ist.

4. Prüffeld (2) nach einem der vorhergehenden Ansprüche,
**dadurch gekennzeichnet, dass**
die Sicherheitssteuerung (46) eine Sicherungsvorrichtung (42) gegen Wiedereinschalten der Betriebsspannung (UB) am PWM-Generator (38) und Wiedereinschalten des Schalters (44) aufweist.

5. Prüffeld (2) nach einem der vorhergehenden Ansprüche,
**dadurch gekennzeichnet, dass**
das Prüffeld (2) wenigstens ein Bedienelement (48) enthält, das dazu eingerichtet ist, in der Sicherheitssteuerung (46) bezüglich wenigstens einer der Prüfstationen (20) den Sicherungszustand (SZ) zu aktivieren, wobei das Bedienelement (48) am Gleichspannungs-Anschluss (28) angeordnet ist.

6. Prüffeld (2) nach Anspruch 5,
**dadurch gekennzeichnet, dass**
das Bedienelement (48) eine Fernsteuerung für die entfernt angeordnete Sicherheitssteuerung (46) ist.

7. Prüffeld (2) nach einem der vorhergehenden Ansprüche,
**dadurch gekennzeichnet, dass**
der Gleichspannungs-Anschluss (28) über eine Versorgungsleitung (50) mit der restlichen Prüfstation (20) verbunden ist und entfernt von der restlichen Prüfstation (20) angeordnet ist.

8. Prüffeld (2) nach einem der vorhergehenden Ansprüche,
**dadurch gekennzeichnet, dass**
der Prüfling (4) nicht über einen Steckverbinder mit dem Gleichspannungs-Anschluss (28) verbunden oder verbindbar ist.

9. Prüffeld (2) nach einem der vorhergehenden Ansprüche,
**dadurch gekennzeichnet, dass** jede Prüfstation (20) des Prüffeldes (2) eine Überwachungseinheit (60) mit einer Ausgabeeinheit (62) enthält, die am Gleichspannungs-Anschluss (28) angeordnet ist,
wobei die Überwachungseinheit (60) dazu eingerichtet ist, im Sicherungszustand (SZ) zu überwachen, ob der PWM-Generator (38) tatsächlich nicht mit der Betriebsspannung (UB) versorgt ist und ob die elektrische Verbindung über den Schalter (44) tatsächlich getrennt ist, und falls nicht, eine Warnmeldung an der Ausgabeeinheit (62) bereitzustellen.

10. Prüffeld (2) nach Anspruch 9,
**dadurch gekennzeichnet, dass** jede Prüfstation (20) des Prüffeldes (2)
eine Diagnoseeinheit (64) enthält, die der Überwachungseinheit (60) zugeordnet ist und die dazu eingerichtet ist, eine Eigendiagnose der Funktionsfähigkeit der Überwachungseinheit (60) durchzuführen, und falls die Funktionsfähigkeit nicht festgestellt wird, das Prüffeld (2) in einen permanenten Fehlerzustand (FZ) zu versetzen.

11. Raumanordnung (52),
mit mindestens zwei Räumen (54,56,58) und mit dem Prüffeld (2) nach einem der vorhergehenden Ansprüche, wobei das Prüffeld (2) verteilt über wenigstens zwei der Räume (54,56,58) in der Raumanordnung (52) derart angeordnet ist, dass der Gleichspannungsanschluss (28) in einem ersten der Räume (54,56,58) angeordnet ist und wenigstens ein Teil des restlichen Prüffeldes (2) in einem zweiten der Räume (54,56,58) angeordnet ist.
